# EUROPEAN PATENT APPLICATION

(11) **EP 3 444 835 A1**
(43) Date of publication of application: **20.02.2019**
(21) Application number: 17782258.2
(22) Date of filing: 30.03.2017
(51) Int. Cl.: H01J 1/34, H01J 9/12

(54) **SPIN-POLARIZED HIGH BRIGHTNESS ELECTRON GENERATING PHOTOCATHODE AND METHOD FOR MANUFACTURING FOR SAME**

(30) Priority: 15.04.2016 JP 2016081955
(71) Applicant: Inter-University Research Institute Corporation High Energy Accelerator Research Organization, Tsukuba-shi Ibaraki 305-0801 (JP)
(72) Inventor: KIN, Shuko, Tsukuba-shi Ibaraki 305-0801 (JP); TAKEDA, Yoshikazu, Nagakute-shi Aichi 480-1142 (JP); YAMAMOTO, Masahiro, Tsukuba-shi Ibaraki 305-0801 (JP); KAMIYA, Yukihide, Tsukuba-shi Ibaraki 305-0801 (JP)
(74) Representative: Horn Kleimann Waitzhofer Patentanwälte PartG mbB
(86) International application number: PCT/JP2017/013496
(87) International publication number: WO 2017/179440

(57) **Abstract**

An object of the present invention is to provide a spin-polarized high brightness electron generating photocathode having a simple structure and used for back illumination and a method for manufacturing the same. A thin film of a single-crystal compound semiconductor having the NEA property is formed on a single-crystal substrate having nanometer-level surface flatness. The spin-polarized high brightness electron generating photocathode of the present invention can be manufactured by metal organic chemical vapor deposition.

## Description

### Technical Field

The present invention relates to a spin-polarized high brightness electron generating photocathode and a method for manufacturing the same.

### Background Art

Spin-polarized electrons in the present invention refer to electrons in the state in which the abundance rates of upward electron spins and downward electron spins are not the same. An NEA property refers to the state in which the vacuum level is lower than the conduction band of a semiconductor in terms of energy, which is referred to as negative electron affinity or the state of negative electron affinity. Having the NEA property may generate spin-polarized electrons, or may not generate spin-polarized electrons. A spin-polarized electron generating ability means to have the ability to generate spin-polarized electrons when electrons in the conduction band of a semiconductor move to a vacuum level. A high brightness electron generating substance is a substance capable of absorbing light and generating high brightness electrons. A spin-polarized electron generating substance is a substance capable of absorbing polarized light, such as polarized laser light, and generating spin-polarized electrons. The spin-polarized high brightness electron generating photocathode of the present invention is a photocathode which absorbs light to generate high brightness electrons and absorbs polarized light, such as polarized laser light, to generate spin-polarized high brightness electrons.

Conventionally, inventions that relate to back-illuminated spin-polarized electron generating device have been proposed (Patent Literatures 1 to 4). Patent Literature 1 discloses a spin-polarized electron generating device in which an intermediate layer or buffer layer containing GaAs as a main component is stacked on a GaAs substrate, about ten superlattice layers of GaAs-GaAsP are stacked thereon, and a thin film of GaAs or other materials (hereinafter abbreviated as "NEA active layer") is formed thereon. Patent Literature 2 discloses a spin-polarized electron generating device in which an intermediate layer or buffer layer containing AlGaInN as a main component is stacked on a GaN substrate, about ten superlattice layers of GaAs-GaAsP are stacked thereon, and an NEA active layer of GaAs or other materials is formed thereon. Patent Literature 3 discloses a spin-polarized electron generating device in which at least an intermediate layer or buffer layer containing AlGaAsP as a main component is stacked on a GaP substrate, about ten superlattice layers of GaAs-GaAsP are stacked thereon, and an NEA active layer of GaAs or other materials is formed thereon. Patent Literature 4 discloses a spin-polarized electron generating device in which an intermediate layer or buffer layer containing InGaAs as a main component is stacked on a GaAs substrate, about ten superlattice layers of GaAs-GaAsP are stacked thereon, and an NEA active layer of GaAs or other materials is formed thereon.

Conventional back-illuminated spin-polarized electron generating devices can generate electrons with a spin polarization degree of about 90%, but have points to be improved in practical use; for example, they have very small quantum efficiency for converting light into electrons (about 0.4% or less), have difficulty in generating high brightness electrons (have a very low brightness of about 10³ Acm⁻²sr⁻¹), require a very complicated manufacturing process because an intermediate layer or buffer layer is indispensable between the substrate and the uppermost layer which is an NEA active layer of GaAs or other materials, and the excitation light for exciting the devices for the absorption edge of light transmission of the substrate used is limited within a narrow wavelength range.

However, back-illuminated spin-polarized high brightness electron generating photocathodes which can generate high brightness electrons with high quantum efficiency while maintaining a spin polarization degree as high as about 90% or more, have a simple structure, and can use excitation light in a wide wavelength range; and methods for manufacturing the same are little known.

### Citation List

### Patent Literature

Patent Literature 1: Japanese Patent Laid-Open No. 2008-198360
Patent Literature 2: Japanese Patent Laid-Open No. 2009-266809
Patent Literature 3: Japanese Patent Laid-Open No. 2013-235750
Patent Literature 4: Japanese Patent Laid-Open No. 2014-075214
Patent Literature 5: WO-A1-1997-03453
Patent Literature 6: WO-A1-1998-54750
Patent Literature 7: WO-A1-2001-009915
Patent Literature 8: WO-A1-2006-130430
Patent Literature 9: Japanese Patent Laid-Open No. 5-266857
Patent Literature 10: Japanese Patent Laid-Open No. 10-149761
Patent Literature 11: Japanese Patent Laid-Open No. 10-188782
Patent Literature 12: Japanese Patent Laid-Open No. 2000-021296
Patent Literature 13: Japanese Patent Laid-Open No. 2000-149767
Patent Literature 14: Japanese Patent Laid-Open No. 2007-123176
Patent Literature 15: Japanese Patent Laid-Open No. 2010-245349
Patent Literature 16: Japanese Patent Laid-Open No. 2010-245352
Patent Literature 17: Japanese Patent Laid-Open No. 2010-257962
Patent Literature 18: Japanese Patent Laid-Open No. 2015-088403
Patent Literature 19: Japanese Patent Laid-Open No. 2015-093250
Patent Literature 20: Japanese Patent Laid-Open No. 2016-139695
Patent Literature 21: Japanese Patent Laid-Open No. 8-116091
Patent Literature 22: Japanese Patent Laid-Open No. 2007-266599
Patent Literature 23: Japanese Patent Laid-Open No. 2000-150960
Patent Literature 24: US-B1-006337536
Patent Literature 25: Japanese Patent Laid-Open No. 2006-66556
Patent Literature 26: WO-A1-2013-035325
Patent Literature 27: Japanese Patent Laid-Open No. 2008-260682

### Summary of Invention

### Technical Problem

An object of the present invention, which has been made in consideration of the above-described circumstances, is to provide a back-illuminated (also referred to as transmissive) spin-polarized high brightness electron generating photocathode which can generate high brightness electrons with high quantum efficiency while maintaining a spin polarization degree as high as about 90% or more, has a simple structure, and can use excitation light in a wide wavelength range; and a method for manufacturing the same.

### Solution to Problem

The inventors of the present invention have made extensive and intensive studies to achieve the above-described object and, as a result, unexpectedly found that a photocathode consisting only of a single-crystal substrate, which has a nanometer-level flat clean surface, and a thin film of a single-crystal compound semiconductor which is epitaxially grown on the substrate and has spin-polarized electron generating ability can generate electrons, which have a high spin polarization degree and high brightness, with high quantum efficiency, and have completed the present invention based on this finding.

In particular, the present invention includes the following aspects.
1. A spin-polarized high brightness electron generating photocathode including:
   a single-crystal substrate that has a nanometer-level flat clean surface and a band gap in a range of 1.5 to 10 eV; and
   a thin film of one single-crystal compound semiconductor selected for the substrate, the single-crystal compound semiconductor having a band gap in a range of 0.15 to 6.5 eV and an NEA property and being epitaxially grown on the substrate, wherein
   when light in a range of 1.5 to 10 eV is incident on a bottom surface of the single-crystal substrate, an electron beam having an electron beam brightness of about 10⁷ Acm⁻²sr⁻¹ or more is generated from the thin film of the single-crystal compound semiconductor.
2. A spin-polarized high brightness electron generating photocathode including:
   a single-crystal substrate that has a nanometer-level flat clean surface and a band gap in a range of 1.5 to 10 eV; and
   a thin film of one single-crystal compound semiconductor selected for the substrate, the single-crystal compound semiconductor having a band gap in a range of 0.15 to 6.5 eV, an NEA property, and spin-polarized electron generating ability and being epitaxially grown on the substrate, wherein
   when light in a range of 1.5 to 10 eV is incident on a bottom surface of the single-crystal substrate, when polarized laser light in a range of 1.5 to 10 eV is incident on the bottom surface of the single-crystal substrate, an electron beam having an electron beam brightness of about 10⁷ Acm⁻²sr⁻¹ or more and a spin polarization degree of about 90% or more is generated from the thin film of the single-crystal compound semiconductor.
3. The spin-polarized high brightness electron generating photocathode according to Aspect 1 or 2, wherein the single-crystal compound semiconductor is a GaAs-based single-crystal compound semiconductor and the single-crystal substrate is composed of ZnS or ZnTe.
4. The spin-polarized high brightness electron generating photocathode according to Aspect 1 or 2, wherein the single-crystal compound semiconductor is a GaAs-based single-crystal compound semiconductor and the single-crystal substrate is composed of ZnSe.
5. The spin-polarized high brightness electron generating photocathode according to Aspect 1 or 2, wherein the single-crystal compound semiconductor is an InSb-based single-crystal compound semiconductor and the single-crystal substrate is composed of one selected from the group consisting of MgTe, CdTe, CdMnTe, and CdZnTe.
6. The spin-polarized high brightness electron generating photocathode according to Aspect 1 or 2, wherein the single-crystal compound semiconductor is an InN-based single-crystal compound semiconductor and the single-crystal substrate is composed of one selected from the group consisting of single-crystal diamond and cubic boron nitride.
7. The spin-polarized high brightness electron generating photocathode according to Aspect 1 or 2, wherein the single-crystal compound semiconductor is a GaN-based single-crystal compound semiconductor and the single-crystal substrate is composed of one selected from the group consisting of ZnO and hexagonal boron nitride.
8. The spin-polarized high brightness electron generating photocathode according to Aspect 1 or 2, wherein the single-crystal compound semiconductor is a CdS-based single-crystal compound semiconductor and the single-crystal substrate is composed of GaN.
9. The spin-polarized high brightness electron generating photocathode according to any one of Aspects 1 to 8, wherein the single-crystal compound semiconductor has a thickness of 50 to 500 nm.

A spin-polarized high brightness electron generating photocathode of the present invention can be manufactured by metal organic chemical vapor deposition.

### Advantageous Effects of Invention

In the present invention, which is a spin-polarized high brightness electron generating photocathode including: a single-crystal substrate that has a band gap in a range of 1.5 to 10 eV; and a thin film of a single-crystal compound semiconductor that has a band gap in a range of 0.15 to 6.5 eV and is epitaxially grown on the substrate, when light in a range of 1.5 to 10 eV is incident on a bottom surface of the single-crystal substrate, high brightness electrons having a brightness of about 10⁷ Acm⁻²sr⁻¹ or more can be generated at a quantum efficiency as high as about 5.5% or more while a spin polarization degree of 90% or more is maintained. The spin-polarized high brightness electron generating photocathode of the present invention can be manufactured by metal organic chemical vapor deposition.

### Brief Description of Drawings

[Figure 1] Figure 1 is a schematic diagram for explaining the structure of a conventional spin-polarized electron generating device.
[Figure 2] Figure 2 is a schematic diagram for explaining the structure of a spin-polarized high brightness electron generating photocathode of the present invention.
[Figure 3] Figure 3 is a pair of photographs showing an example of the spin-polarized high brightness electron generating photocathode of the present invention.
[Figure 4] Figure 4 is a high-resolution SEM image showing the surface state of the single-crystal substrate in the spin-polarized high brightness electron generating photocathode of the present invention.
[Figure 5] Figure 5 is a high-resolution SEM image showing the surface state of the outermost surface of the spin-polarized high brightness electron generating photocathode of the present invention.
[Figure 6] Figure 6 is a graph showing the relationship between laser power with respect to photocathode current shown by one spin-polarized high brightness electron generating photocathode of the present invention.

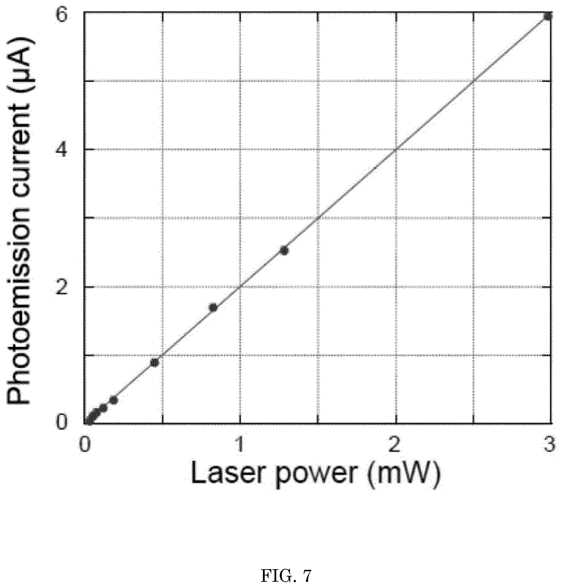

[Figure 7] Figure 7 shows an XRD profile of the spin-polarized high brightness electron generating photocathode of the present invention in which a thin film of a GaAs single-crystal compound semiconductor is formed on a ZnSe single-crystal substrate.

### Description of Embodiments

Although a spin-polarized high brightness electron generating photocathode of the present invention has a very simple structure, surprisingly, it can generate electrons having a spin polarization degree as high as 90% or more and a brightness of 10⁷ Acm⁻²sr⁻¹ or more, with high quantum efficiency. The idea that a photocathode of the present invention having a very simple structure in which a thin film of a single-crystal compound semiconductor having spin-polarized electron generating ability is formed on a light-transmissive single-crystal substrate would probably be able to generate, with high quantum efficiency, electrons having a spin polarization degree as high as 90% or more and a brightness of 10⁷ Acm⁻²sr⁻¹ or more would definitely be unexpected even for those skilled in the art. This is because it has been considered that it is very important to provide an intermediate layer or buffer layer between the substrate and the NEA active layer as described above in a conventional spin-polarized electron device for generating electrons having a high spin polarization degree. Further, conventionally, many devices, such as transmissive photocathodes, photocathodes, photocatalytic devices, photovoltaic power generation devices, and semiconductor devices, consisting of a light-transmissive substrate, an NEA substance layer directly formed on the light-transmissive substrate, a photoelectric conversion layer, a photocatalyst layer, a photosensitizer layer and the like have been proposed (Patent Literatures 5 to 20). Nevertheless, inventions are little known which apply a technique using such a conventional light-transmissive substrate to a spin-polarized high brightness electron generating photocathode like that of the invention. Even if a photocathode having a structure in which only a thin film of a single-crystal compound semiconductor is formed on a conventional transmissive substrate is prepared, it would hardly be able to generate high brightness electrons like those of the present invention. This is because experiments that have been conducted by the inventors of the present invention has demonstrated that a transmissive photocathode in which a wafer having surface flatness of about 10 nm achieved by subjecting the wafer cut out from an ingot of a single-crystal substrate to a mirror finishing process is used as a light-transmissive substrate and a thin film of a single-crystal compound semiconductor is formed thereon has difficulty in generating high brightness electrons.

The surface of the single-crystal substrate in the spin-polarized high brightness electron generating photocathode of the present invention is estimated to be a surface that is nanometer-level flat and clean for epitaxial growth of a thin film of a single-crystal compound semiconductor having the NEA property on the single-crystal substrate. The nanometer level in the present invention is estimated to be about several nanometers at most, although the numerical value of nanometer is not definitely limited thereto. The single-crystal substrate of the spin-polarized high brightness electron generating photocathode of the present invention is estimated to have a nanometer-level flat clean surface from the experimental results that show that a photocathode in which a wafer having surface flatness of about 10 nm achieved by subjecting the wafer cut out from a single-crystal ZnSe ingot to a mirror finishing process is used as a substrate and a thin film of a GaAs single-crystal compound semiconductor is formed thereon generates an electron beam with a brightness of about 10³ Acm⁻²sr⁻¹ or less, whereas only one in which a thin film of a GaAs single-crystal compound semiconductor is formed on the surface of a ZnSe single-crystal substrate fabricated by metal organic chemical vapor deposition that is surface-treated to an extent such that no asperities are observed through high-resolution SEM observation can exhibit an XRD profile belonging to single-crystal GaAs and generate electrons having about 90% spin polarization degree and about 10⁷ Acm⁻²sr⁻¹. In general, it must be very difficult to apply extremely difficult nanometer-level ultra-fine processing to a wafer cut out from a single-crystal ZnSe ingot, check the flatness of its surface using an AFM or the like, and thus prove the necessity of a nanometer-level flat clean surface.

The spin-polarized high brightness electron generating photocathode of the present invention can generate an electron beam having a brightness of about 10⁷ Acm⁻²sr⁻¹ or more because a contact interface between the surface of the single-crystal substrate and the thin film of the single-crystal compound semiconductor is optically very smooth at the nanometer level, so that the optical phenomenon such as undesirable scattering and refraction of the light passing through the single-crystal substrate that occurs at the interface is almost completely suppressed, and this itself is the reason why it is estimated that the surface of the single-crystal substrate of the spin-polarized high brightness electron generating photocathode of the present invention has a nanometer-level flat clean surface. This is because the electron beam brightness of about 10⁷ Acm⁻²sr⁻¹ or more can be regarded as almost corresponding to the theoretical brightness of the electron beam generated when it is assumed that the thin film of the single-crystal compound semiconductor having the NEA property is free from optical scattering factors, for example, spatial disturbance of unit cells in it or at the interface.

The reason why the surface of the single-crystal substrate of the present invention is required to be a clean surface is that it is difficult to epitaxially grow a thin film of a single-crystal compound semiconductor when the surface is covered or contaminated with an oxide film or the like. A clean surface in the present invention refers to that in the state where atoms constituting a single-crystal substrate are present in a bare state on the surface of the single-crystal substrate.

A single-crystal substrate of the present invention is light transmissive so that the spin-polarized high brightness electron generating photocathode, which is the object of the present invention, is transmissive. The single-crystal substrate preferably has a band gap in the range of 1.5 eV (826 nm) to 10 eV (124 nm) because it can transmit light in the ultraviolet to visible region according to the value of the band gap.

A thin film of a single-crystal compound semiconductor of the present invention is preferably a thin film of a single-crystal compound semiconductor having a band gap in the range of 0.15 eV (8260 nm) to 6.5 eV (190 nm) and having the NEA property, because it efficiently absorbs light in the ultraviolet to visible region passing through the single-crystal substrate and generates spin-polarized electrons.

The spin-polarized high brightness electron generating photocathode of the present invention consists of the single-crystal substrate and the thin film of the single-crystal compound semiconductor epitaxially grown on the substrate. In use, usually the thin film of the single-crystal compound semiconductor is subjected to NEA activation treatment. The NEA activation treatment is treatment for assisting efficient generation of electrons from a substance having the NEA property and outside the substance and is usually achieved by doping a target object with an NEA activator or adsorption of the NEA activator onto the target object. Known examples of such an NEA activator include a pair of oxygen and an alkali metal which easily releases electrons. Further, the spin-polarized high brightness electron generating photocathode of the present invention consists of the single-crystal substrate and the thin film of the single-crystal compound semiconductor epitaxially grown on the substrate, so that an intermediate layer or buffer layer is not formed on the single-crystal substrate; however, this does not deny the superlattice structure of the single-crystal compound semiconductor. However, in the case where the superlattice structure of the single-crystal compound semiconductor is formed on the single-crystal substrate, an intermediate layer or buffer layer for lattice matching between the superlattice structure of the single-crystal compound semiconductor and the single-crystal substrate; thus, in the present invention, the superlattice structure of the single-crystal compound semiconductor is rarely formed on the single-crystal substrate.

One having the NEA property is used as the single-crystal compound semiconductor used for the spin-polarized high brightness electron generating photocathode of the present invention. An appropriate type of single-crystal substrate is selected depending on the type of single-crystal compound semiconductor. It is preferable that the single-crystal substrate and the corresponding single-crystal compound semiconductor have the same crystal system and their lattice constants are similar so that the single-crystal compound semiconductor epitaxially grows on the single-crystal substrate. The similarity between the single-crystal compound semiconductor and the lattice constant of the single-crystal substrate generally means that the single-crystal compound semiconductor has a lattice constant that has a mismatch within several percentages, preferably 1%, with the lattice constant of the single-crystal substrate. However, in the present invention, a single-crystal compound semiconductor can be epitaxially grown on a single-crystal substrate even when the lattice constant mismatch is not within the range of several percentages. This is because the surface of the single-crystal substrate used in the present invention is a clean surface having nanometer-level flatness.

Single-crystal compound semiconductors and single-crystal substrates suitable for the present invention are (1) one single-crystal substrate selected from the group consisting of ZnS (3.6 eV), ZnSe (2.67 eV), and ZnTe (1.4 eV) for a GaAs-based single-crystal compound semiconductor, (2) one single-crystal substrate selected from the group consisting of BaF₂ (9.53 eV) and CaF₂ (9.53 eV) for an InSb-based single-crystal compound semiconductor, (3) one single-crystal substrate selected from the group consisting of single-crystal diamond (5.47 eV) and cubic boron nitride (6 eV) for an InN-based single-crystal compound semiconductor, (4) one single-crystal substrate selected from the group consisting of ZnO (3.436 eV) and hexagonal boron nitride (6 eV) for a GaN-based single-crystal compound semiconductor, and (5) a GaN (3.4 eV) single-crystal substrate for a CdS-based single-crystal compound semiconductor.

The GaAs-based single-crystal compound semiconductor is a single-crystal compound semiconductor that belongs to the same crystal system as the crystal system (cubic system) of GaAs and has a lattice constant similar to the lattice constant of GaAs. Examples of such a single-crystal compound semiconductor include GaAs, GaP, GaSb, InP, InAs, ZnSe, ZnS, ZnTe, BeSe, BeTe, MgS, MgSe, CdSe, GaSe, GaBi, InGaAs, InAsP, GaAsP, GaAsSb, GaAsAl, and InGaAlP. Among these, GaAs (1.43 eV), GaP (2.26 eV), GaSb (0.67 eV), InP (1.29 eV), InAs (0.36 eV), InGaAs, InAsP, GaAsP, GaAsSb, GaAsAl, and InGaAlP are preferred for their great NEA properties. As the GaAs, Ga₁As₁₋ₓ (0 ≤ x ≤ 1) or Ga₁As₁₋ₓ (0 ≤ x ≤ 1) containing at least one element selected from the group consisting of Cs, Rb, Ce, Sb, Te, In, Al, P, N and Zn can be used. Ga₁As₁₋ₓ (0 ≤ x ≤ 1) containing at least one element selected from the group consisting of Cs, Rb, Ce, Sb, Te, In, Al, P, N and Zn yields higher spin-polarized electron generating ability of Ga₁As₁₋ₓ (0 ≤ x ≤ 1). In particular, Zn atoms contained are suitable for enhancing the spin-polarized electron generating ability of the thin film of all single-crystal compound semiconductors used in the present invention. The content of Zn atoms usually ranges from 10¹⁸ cm⁻³ to 10²⁰ cm⁻³ per unit volume of the single-crystal compound semiconductor used.

The InSb-based single-crystal compound semiconductor is a single-crystal compound semiconductor that belongs to the same crystal system as the crystal system (cubic system) of InSb and has a lattice constant similar to the lattice constant of InSb. Examples of such a single-crystal compound semiconductor include InSb, CdZnTe, CdMnTe, CdTe, ZnTe, and MgTe. Among these, InSb (0.17 eV) is preferred for its comparatively high NEA property. As the InSb, In₁Sb₁₋ₓ (0 ≤ x ≤ 1) or In₁Sb₁₋ₓ (0 ≤ x ≤ 1) containing at least one element selected from the group consisting of Cs, Rb, Ce, Ga, As, Te, Al, P, N, and Zn can be used. In₁Sb₁₋ₓ (0 ≤ x ≤ 1) containing at least one element selected from the group consisting of Cs, Rb, Ce, Ga, As, Te, Al, P, N and Zn yields higher spin-polarized electron generating ability of In₁Sb₁₋ₓ (0 ≤ x ≤ 1).

The InN-based single-crystal compound semiconductor is a single-crystal compound semiconductor that belongs to the same crystal system as the crystal system (cubic system) of InN and has a lattice constant similar to the lattice constant of InN. Examples of such a single-crystal compound semiconductor include InN, LaB₆, and CeB₆. Among these, InN (0.7 eV) is preferred for its comparatively high NEA property. As the InN, In₁N₁₋ₓ (0 < x < 1) or In₁N₁₋ₓ (0 < x < 1) containing at least one element selected from the group consisting of Cs, Rb, Ce, Sb, Te, Al, P, and Zn can be used. In₁N₁₋ₓ (0 < x < 1) containing at least one element selected from the group consisting of Cs, Rb, Ce, Sb, Te, Al, P, and Zn yields higher spin-polarized electron generating ability of In₁N₁₋ₓ (0 < x < 1).

The GaN-based single-crystal compound semiconductor is a single-crystal compound semiconductor that belongs to the same crystal system as the crystal system (wurtzite structure) of GaN and has a lattice constant similar to the lattice constant of GaN. Examples of such a single-crystal compound semiconductor include GaN and AlN. Among these, GaN (3.4 eV) and AlN (6.3 eV) are preferred for their comparatively high NEA property. As the GaN, Ga₁N₁₋ₓ (0 < x < 1) or Ga₁N₁₋ₓ (0 < x < 1) containing at least one element selected from the group consisting of Cs, Rb, Ce, Sb, Te, In, Al, P, and Zn can be used. Ga₁N₁₋ₓ (0 < x < 1) containing at least one element selected from the group consisting of Cs, Rb, Ce, Sb, Te, In, Al, and P yields higher spin-polarized electron generating ability of Ga₁N₁₋ₓ (0 < x < 1).

The CdS-based single-crystal compound semiconductor is a single-crystal compound semiconductor that belongs to the same crystal system as the crystal system (hexagonal system or cubic system) of CdS and has a lattice constant similar to the lattice constant of CdS. Examples of such a single-crystal compound semiconductor include CdS and CdSe. Among these, CdS (2.42 eV) and CdSe (1.73 eV) are preferred for their comparatively high NEA property.

Examples of the single-crystal substrate for the GaAs-based single-crystal compound semiconductor include CaF₂, CeO₂, NaCl, YSZ, ZnS, ZnSe, ZnTe, ZrO₂, and spinel structure Li₂TiO₄. Among these, ZnS (3.6 eV), ZnSe (2.67 eV), and ZnTe (1.4 eV) are preferred because they belong to the same crystal system as the crystal system of the GaAs-based single-crystal compound semiconductor and have a lattice constant similar to the lattice constant of GaAs and excellent light transmissivity. As the ZnSe, Zn₁Se₁₋ₓ (0 ≤ x ≤ 1) or Zn₁Se₁₋ₓ (0 ≤ x ≤ 1) containing at least one element selected from the group consisting of O and N can be used. Zn₁Se₁₋ₓ (0 ≤ x < 1) containing at least one element selected from the group consisting of O and N improves the adjustment of the light transmissivity of Zn₁Se₁₋ₓ (0 ≤ x < 1) and the matching of Zn₁Se₁₋ₓ (0 ≤ x < 1) with GaAs in lattice constant. The same as ZnSe applies to ZnS and ZnTe.

Since ZnS, ZnSe, and ZnTe are conventionally II-VI group compound semiconductors, semiconductor light-emitting elements in which a III-V group compound semiconductor layer of GaN or the like is formed on ZnS or ZnSe have been proposed, for example (Patent Literature 21). However, the II-IV group compound semiconductor layer of GaN or the like consists of a buffer layer of n-type GaN, a cladding layer of n-type AlₓGa₁₋ₓN (0 < x < 1), an active layer of Ga_{q}In_{1-q}N (0 < q < 1), and a cap layer of p-type GaN, and does not have a structure in which a GaAs-based compound semiconductor layer is directly formed on ZnS or ZnSe as in the present invention. In addition, for example, a light-emitting element (Patent Literature 22) has been proposed in which a compound semiconductor is formed on ZnSe containing, as an impurity element(s), at least one element selected from the group consisting of manganese (Mn), europium (Eu), samarium (Sm), terbium (Tb), praseodymium (Pr), thulium (Tm), cerium (Ce), copper (Cu), silver (Ag), chlorine (Cl), and fluorine (F); and light-emitting elements have been proposed in which an epitaxial light-emitting structure including a ZnSe, ZnCdSe, or ZnSeTe-based active layer is formed on an n-type ZnSe substrate containing I, Al, Br, Cl, Ga, or In as an impurity element (Patent Literatures 23 and 24). However, the impurity contained in the ZnSe is used not to improve the light transmissivity of a single-crystal substrate as in the present invention but in such a manner that the blue color from the active layer causes the dopant of ZnSe to emit yellow orange fluorescence so that the intermediate color of reddish purple, pink, and violet is generated by the blue color and the yellow orange color.

Examples of the single-crystal substrate for the InSb-based single-crystal compound semiconductor include BaF₂ and CaF₂. Among these, BaF₂ and CaF₂ are preferred because they belong to the same crystal system as the crystal system of the InSb-based single-crystal compound semiconductor and have a lattice constant similar to the lattice constant of InSb and excellent light transmissivity.

Examples of the single-crystal substrate for the InN-based single-crystal compound semiconductor include single-crystal diamond, KTaO₃, LSAT (a mixed oxide of lanthanum, strontium, aluminum, and tantalum), LiF, SrTiO₃, and cubic boron nitride. Among these, single-crystal diamond (5.47 eV) and cubic boron nitride (6 eV) are preferred because they belong to the same crystal system as the crystal system of the InN-based single-crystal compound semiconductor and have a lattice constant similar to the lattice constant of InN and excellent light transmissivity.

Conventionally, a semiconductor element has been proposed (Patent Literature 25) in which any one of n-type AlN, p-type AlN, n-type boron nitride (BN), p-type BN, n-type silicon carbide (SiC), p-type SiC, n-type diamond, and p-type diamond is used as a substrate, an undoped AlN layer, an n-type AlN layer, and a p-type AlN layer are epitaxially grown on the substrate to form a pn junction of AlN so that the undoped AlN layer with less defects gives the n-type AlN layer and the p-type AlN layer having excellent electrical characteristics, and the light emission output at or around the emission wavelength of 200 nm can be greatly increased. However, what is formed on the substrate is not a thin film of an InN-based single-crystal compound semiconductor as in the present invention but an AlN layer.

Examples of the single-crystal substrate for the GaN-based single-crystal compound semiconductor include hexagonal boron nitride, MgF, TiO₂, ZnO, and AlN. Among these, hexagonal boron nitride (6 eV) and ZnO (3.436 eV) are preferred because they belong to the same crystal system as the crystal system of the GaN-based single-crystal compound semiconductor and have a lattice constant similar to the lattice constant of GaN and excellent light transmissivity.

It has conventionally been proposed to form a wurtzite-type AlₓGa₁₋ₓN (x > 0) thin film (14) as a buffer layer on a graphite-type boron nitride thin film (12) and further grow a wurtzite-type AlGaInBN (13) nitride semiconductor, such as GaN, thereon (Patent Literature 26). However, a wurtzite-type AlₓGa₁₋ₓN (x > 0) (14) needs to be formed as a buffer layer in order to grow the wurtzite-type AlGaInBN nitride semiconductor (13) structure, such as GaN, on the graphite-type boron nitride thin film, a thin film of a GaN-based single-crystal compound semiconductor is not directly formed on a single-crystal substrate of hexagonal boron nitride or ZnO as in the present invention. In addition, a semiconductor element (Patent Literature 27), such as a light-emitting element or a diode, has conventionally been proposed which is formed by forming single-crystal films 12, 14, and 15 composed of at least one III-V group nitride selected from the group consisting of aluminum nitride, boron nitride, indium nitride, and a mixed crystal of these substances, on a III-V group nitride single-crystal substrate 11 which contains transition metal of 10 ppb or more and 0.1 mol% or less and in which the half-value width of the rocking curve in X-ray diffraction is 1.5 or less and the main surface consists of a (0001) cleavage plane or a (1-100) cleavage plane and a vertical polished surface, by MOCVD directly or through a III-V group nitride low-temperature buffer layer 13. However, what is formed on the boron nitride is single-crystal films of aluminum nitride, boron nitride, and indium nitride belonging to the same group, unlike in the present invention in which a thin film of a GaN-based single-crystal compound semiconductor is directly formed on a single-crystal substrate of hexagonal boron nitride.

Examples of the single-crystal substrate for the CdS-based single-crystal compound semiconductor include CdSe, BaTiO₃, CaCO₃, DyScO₃, GaN, GaScO₃, LiAlO₂, LiGaO₂, SiO₂, TbScO₃, and YAlO₃. Among these, GaN (3.4 eV) is preferred because it belongs to the same crystal system as the crystal system of the CdS-based single-crystal compound semiconductor and has a lattice constant similar to the lattice constant of CdS and excellent light transmissivity.

A preferable range of the thickness of the thin film of a single-crystal compound semiconductor can be determined based on the generation efficiency of electrons by light absorption. The thickness of the thin film of a single-crystal compound semiconductor of the present invention is preferably usually in the range of 50 to 500 nm. It can be used even with a thickness smaller than 50 nm, for example, about 5 nm, but a too small thickness is not preferable because its life gets short. Although it can be used even with a thickness larger than 500 nm, for example, about 1000 nm, electrons generated in the single-crystal compound semiconductor by light absorption are less likely to jump out of the surface, which is not very preferable.

Regarding the spin-polarized electron generating photocathode of the present invention, when light in the range of 1.5 to 10 eV is incident on the bottom surface of the single-crystal substrate in the spin-polarized electron generating photocathode, an electron beam having an electron beam brightness of 10⁷ Acm⁻²sr⁻¹ or more can be generated from a thin film of a single-crystal compound semiconductor in the spin-polarized electron generating photocathode. The present invention is the first invention to provide a photocathode that can generate an electron beam with an electron beam brightness of 10⁷ Acm⁻²sr⁻¹ or more, which has been little known, conventionally. The electron beam brightness of 10⁷ Acm⁻²sr⁻¹ is at least 10,000 times higher than the electron beam brightness of electrons generated by conventional back-illuminated spin-polarized electron generating devices (Patent Literatures 1 to 4). A possible reason for this is that the spin-polarized electron generating photocathode of the present invention does not have an intermediate layer, a buffer layer, and a superlattice layer on the single-crystal substrate. In addition, the quantum efficiency and electron beam brightness of the spin-polarized electron generating photocathode of the present invention are approximately 5.5% or more and 1 × 10⁷ Acm⁻²sr⁻¹ or more, respectively, which are at least 10 times and 10,000 times higher, respectively, than the quantum efficiency and electron beam brightness of electrons generated by the conventional back-illuminated spin-polarized electron generating devices (Patent Literatures 1 to 4). This is also because, in the spin-polarized electron generating photocathode of the present invention, the surface of the single-crystal substrate is clean and flat at the level of several nanometers at most, eliminating the necessity of an intermediate layer or buffer layer on the single-crystal substrate. In the thin film of a single-crystal compound semiconductor formed on the single single-crystal substrate, the electron energy distribution in the vicinity of the interface with the single-crystal substrate and the electron energy distribution in the vicinity of the surface of the thin film of the single-crystal compound semiconductor tend to decay exponentially toward the vicinity of the surface, which is low energy dispersion. This also contributes to a great improvement in the brightness of electron beam.

Regarding the spin-polarized high brightness electron generating photocathode of the present invention, when polarized laser light in the range of 1.5 to 10 eV is incident on the bottom surface of the single-crystal substrate in the spin-polarized electron generating photocathode, a highly spin-polarized high brightness electron beam having an electron beam brightness of 10⁷ Acm⁻²sr⁻¹ or more and a spin polarization degree as high as 90% or more can be generated from the thin film of the single-crystal compound semiconductor in the spin-polarized electron generating photocathode. The spin polarization degree of 90% or more is comparable to the spin polarization degree of electrons generated by conventional back-illuminated spin-polarized electron generating devices (Patent Literatures 1 to 4). The present invention is the first invention to show that the spin-polarized high brightness electron generating photocathode of the present invention can generate highly spin-polarized high brightness electrons regardless of its very simple structure, which has been little known, conventionally.

The spin-polarized high brightness electron generating photocathode of the present invention can be fabricated by forming the single-crystal substrate and the thin film of the single-crystal compound semiconductor of the spin-polarized electron generating photocathode by using metal organic chemical vapor deposition. To be specific, an organometallic gas corresponding to the composition ratio of a single-crystal substrate to be fabricated is passed on, for example, a sapphire substrate heated together with a carrier gas in an inert gas closed container at atmospheric pressure, thereby causing the thermal decomposition of the organometallic gas on the heated sapphire substrate and thus forming a single-crystal substrate on the heated sapphire substrate. Next, an organometallic gas corresponding to the composition ratio of a single-crystal compound semiconductor to be fabricated is passed on the obtained single-crystal substrate together with a carrier gas while causing the thermal decomposition of the organometallic gas on the substrate, thereby forming a thin film of a single-crystal compound semiconductor on the single-crystal substrate. Thus, a spin-polarized high brightness electron generating photocathode of the present invention can be fabricated. Other possible methods include a molecular beam epitaxial (MBE) method which has problems in that the operation method of the MBE method is complicated, processing for a large area is difficult with it, and the like; thus, it is not preferred for industrial use. In contrast, the metal organic chemical vapor deposition used in the present invention can be achieved with a relatively easy operation method and enables processing for a large area; thus, it is very preferable for industrial use.

One aspect of the present invention will now be described in detail as an embodiment (hereinafter also referred to as "this embodiment") with reference to the drawings. The brightness of an electron beam is determined by dividing the current value related to the electron beam generated from a thin film of a single-crystal compound semiconductor of a sample when the substrate side of the sample is irradiated with light, by the cross sectional area and the solid angle value of the emitted electron beam. The degree of spin polarization of an electron beam is determined by detecting laser inverse Compton scattering gamma rays or X-rays backscattered in the direction of travel of the electron beam through Compton polarimetry when the electron beam, which is generated from a thin film of the single-crystal compound semiconductor of the sample when the substrate side of the sample is irradiated with light, is irradiated with polarized laser light (usually circularly polarized laser light). At this time, if the circularly polarized light of the laser is laterally turned, for the transversely polarized electrons, a difference appears in upper-lower or left-right asymmetry in the scattering angle distribution of the backscattered gamma rays or X-rays and, for the longitudinally polarized electrons, a difference appears in the energy distribution of backscattered gamma rays or X rays; therefore, the upper-lower distribution or energy distribution of the backscattered gamma rays or X rays is measured, the degree of asymmetry relative to the left-right circularly polarized light is determined, and the polarization degree of the electron beam can be measured as the ratio to the degree of asymmetry at 100% polarization.

### Comparative Example

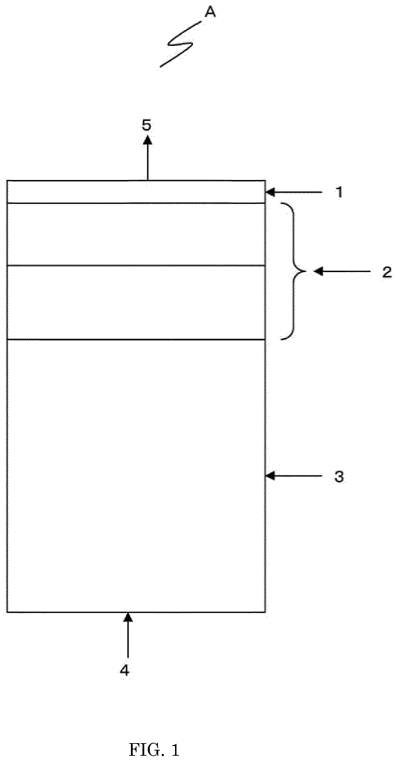

Figure 1 is a schematic diagram for explaining the structure of a conventional spin-polarized electron generating device. A conventional spin-polarized electron generating device A, which is a spin-polarized electron generating device in which at least an intermediate layer or buffer layer 2 is formed on a substrate 3 and an NEA active layer 1 is further formed thereon, not only has a very complicated structure of the device itself but also requires a very sophisticated manufacturing method such as the molecular beam epitaxial (MBE) method in some cases. The lower part of the substrate 3 is irradiated with excitation light 4, and spin-polarized electrons (high brightness electrons) are generated from the NEA active layer 1.

### Example 1

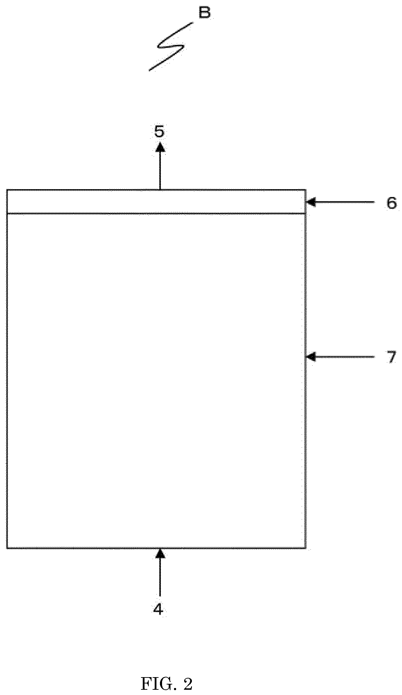

Figure 2 is a schematic view for explaining the structure of a spin-polarized high brightness electron generating photocathode of the present invention consisting of a single single-crystal substrate selected for a single-crystal compound semiconductor which absorbs light and generates spin-polarized electrons, and a thin film of a single-crystal compound semiconductor which is epitaxially grown on the single-crystal substrate and has spin-polarized electron generating ability. The surface of the single-crystal substrate for forming the thin film of the single-crystal compound semiconductor has a flatness of nanometer level. The single-crystal substrate usually has a band gap in the range of 1.5 to 10 eV. The single-crystal compound semiconductor usually has a band gap in the range of 0.15 to 6.5 eV. In addition, the single-crystal compound semiconductor usually has a thickness of 50 to 500 nm.

### Example 2

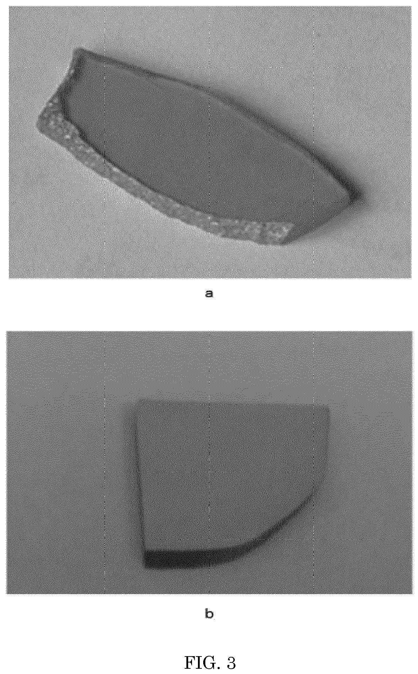

As shown in Figure 3, observation of the surface of a ZnSe single-crystal substrate which is a single-crystal substrate of the spin-polarized high brightness electron generating photocathode of the present invention using a high-resolution SEM shows that the surface of the ZnSe single-crystal substrate is so flat that no asperities are observed.

### Example 3

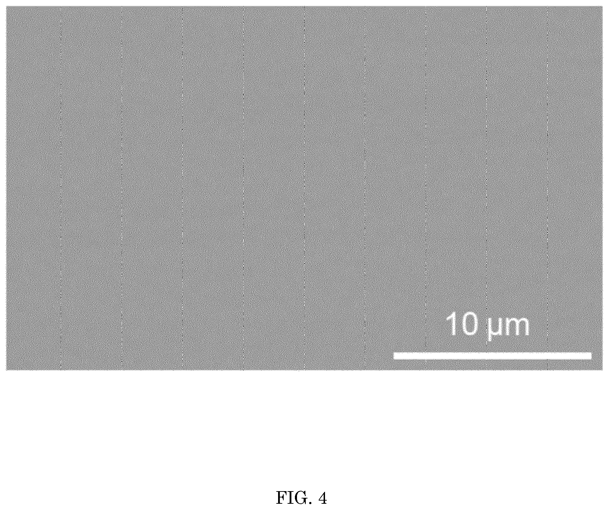

As shown in Figure 4, observation of the outermost surface of a thin film of a GaAs single-crystal compound semiconductor of the spin-polarized high brightness electron generating photocathode of the present invention using a high-resolution SEM shows that the outermost surface of the thin film of the GaAs single-crystal compound semiconductor is so flat that no asperities are observed.

### Example 4

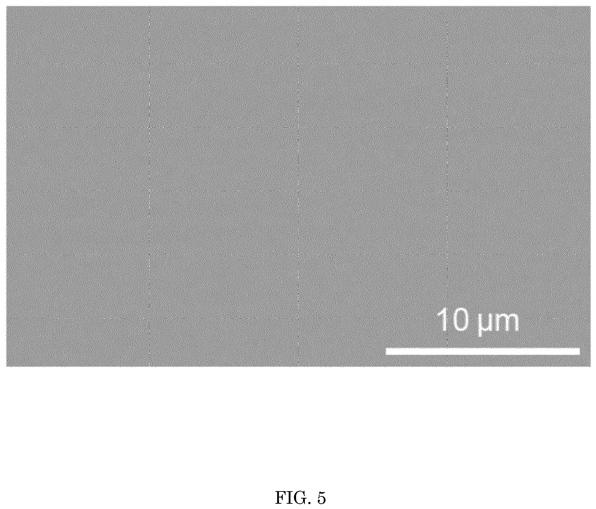

As shown in Figure 5, through XRD measurement that was performed on the spin-polarized high brightness electron generating photocathode of the present invention in which the thin film of the GaAs single-crystal compound semiconductor (having a thickness of about 300 nm) is formed on the ZnSe single-crystal substrate, a peak (a) related to the single crystal ZnSe and a peak (b) related to the single-crystal compound semiconductor GaAs are observed. This shows that the thin film of the GaAs single-crystal compound semiconductor is epitaxially grown on the ZnSe single-crystal substrate.

### Example 5

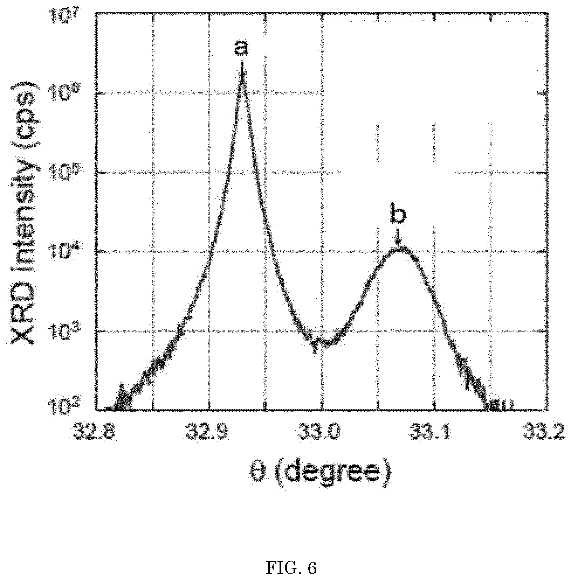

As shown in Figure 6, the relationship between laser power and photocathode current was investigated by irradiating one in which a thin film of a GaAs single-crystal compound semiconductor having a thickness of about 300 nm is formed on a ZnSe single-crystal substrate with laser light having a wavelength of 785 nm, and the results show that the current value of electrons generated from the surface of the thin film of the GaAs single-crystal compound semiconductor is directly proportional to the power of irradiation light.

### Example 6

Regarding a photocathode consisting of a ZnSe single-crystal substrate and a thin film (having a thickness of about 300 nm) of a GaAs single-crystal compound semiconductor epitaxially grown on the single-crystal substrate, the electron beam generated upon irradiation of the photocathode with laser light having a wavelength of 532 nm exhibits an electron beam brightness of about 1 × 10⁷ Acm⁻²sr⁻¹.

### Example 7

Regarding a photocathode consisting of a ZnSe single-crystal substrate and a thin film (having a thickness of about 300 nm) of a GaAs (containing Zn) single-crystal compound semiconductor epitaxially grown on the single-crystal substrate, the electron beam generated upon irradiation of the photocathode with polarized laser light having a wavelength of 785 nm exhibits a spin polarization degree of about 90% and an electron beam brightness of about 1 × 10⁷ Acm⁻²sr⁻¹.

### Example 8

Regarding a photocathode consisting of a ZnS single-crystal substrate and a thin film (having a thickness of about 300 nm) of a GaAs single-crystal compound semiconductor epitaxially grown on the single-crystal substrate, the electron beam generated upon irradiation of the photocathode with laser light having a wavelength of 532 nm exhibits an electron beam brightness of about 1 × 10⁷ Acm⁻²sr⁻¹.

### Example 9

Regarding a photocathode consisting of a ZnS single-crystal substrate and a thin film (having a thickness of about 300 nm) of a GaAs (containing Zn) single-crystal compound semiconductor epitaxially grown on the single-crystal substrate, the electron beam generated upon irradiation of the photocathode with polarized laser light having a wavelength of 532 nm exhibits a spin polarization degree of about 90% and an electron beam brightness of about 1 × 10⁷ Acm⁻²sr⁻¹.

### Example 10

Regarding a photocathode consisting of a ZnTe single-crystal substrate and a thin film (having a thickness of about 300 nm) of a GaAs single-crystal compound semiconductor epitaxially grown on the single-crystal substrate, the electron beam generated upon irradiation of the photocathode with laser light having a wavelength of 1060 nm exhibits an electron beam brightness of about 1 × 10⁷ Acm⁻²sr⁻¹.

### Example 11

Regarding a photocathode consisting of a ZnTe single-crystal substrate and a thin film (having a thickness of about 300 nm) of a GaAs (containing Zn) single-crystal compound semiconductor epitaxially grown on the single-crystal substrate, the electron beam generated upon irradiation of the photocathode with polarized laser light having a wavelength of 1060 nm exhibits a spin polarization degree of about 90% and an electron beam brightness of about 1 × 10⁷ Acm⁻²sr⁻¹.

### Example 12

Regarding a photocathode consisting of a MgTe single-crystal substrate and an InSb single-crystal compound semiconductor epitaxially grown on the substrate, the electron beam generated upon irradiation of the photocathode with laser light having a wavelength of 532 nm exhibits an electron beam brightness of about 1 × 10⁷ Acm⁻²sr⁻¹.

### Example 13

Regarding a photocathode consisting of a MgTe single-crystal substrate and an InSb (containing Zn) single-crystal compound semiconductor epitaxially grown on the substrate, the electron beam generated upon irradiation of the photocathode with laser light having a wavelength of 532 nm exhibits a spin polarization degree of about 90% and an electron beam brightness of about 1 × 10⁷ Acm⁻²sr⁻¹.

### Example 14

Regarding a photocathode consisting of a diamond single-crystal substrate and an InN single-crystal compound semiconductor epitaxially grown on the substrate, the electron beam generated upon irradiation of the photocathode with laser light having a wavelength of 532 nm exhibits an electron beam brightness of about 1 × 10⁷ Acm⁻²sr⁻¹.

### Example 15

Regarding a photocathode consisting of a single-crystal substrate of cubic boron nitride or wurtzite structure boron nitride and an InN single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 16

Regarding a photocathode consisting of a single-crystal substrate of cubic boron nitride or wurtzite structure boron nitride and an InN (containing Zn) single-crystal compound semiconductor epitaxially grown on the substrate, the electron beam generated upon irradiation of the photocathode with polarized laser light having a wavelength of 532 nm exhibits a spin polarization degree of about 90% and an electron beam brightness of about 1 × 10⁷ Acm⁻²sr⁻¹.

### Example 17

Regarding a photocathode consisting of a ZnO single-crystal substrate and a GaN single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 18

Regarding a photocathode consisting of a ZnO single-crystal substrate and a GaN (containing Zn) single-crystal compound semiconductor epitaxially grown on the substrate, the electron beam generated upon irradiation of the photocathode with polarized laser light having a wavelength of 532 nm exhibits a spin polarization degree of about 90% and an electron beam brightness of about 1 × 10⁷ Acm⁻²sr⁻¹.

### Example 19

Regarding a photocathode consisting of a hexagonal boron nitride single-crystal substrate and a GaN single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 20

Regarding a photocathode consisting of a hexagonal boron nitride single-crystal substrate and a GaN (containing Zn) single-crystal compound semiconductor epitaxially grown on the substrate, the electron beam generated upon irradiation of the photocathode with polarized laser light having a wavelength of 532 nm exhibits a spin polarization degree of about 90% and an electron beam brightness of about 1 × 10⁷ Acm⁻²sr⁻¹.

### Example 21

Regarding a photocathode consisting of a single-crystal substrate of cubic boron nitride or wurtzite structure boron nitride and an InN single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 22

Regarding a photocathode consisting of a ZnO single-crystal substrate and a GaN single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 23

Regarding a photocathode consisting of a hexagonal boron nitride single-crystal substrate and a GaN single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 24

Regarding a photocathode consisting of a GaN single-crystal substrate and a CdS single-crystal compound semiconductor epitaxially grown on the substrate, the electron beam generated upon irradiation of the photocathode with polarized laser light having a wavelength of 532 nm exhibits an electron beam brightness of about 1 × 10⁷ Acm⁻²sr⁻¹.

### Example 25

A spin-polarized high brightness electron generating photocathode of the present invention can be manufactured by metal organic chemical vapor deposition. For example, a gas of organometallic zinc and a gas of organometallic selenium corresponding to the composition ratio in a ZnSe single-crystal substrate to be fabricated is passed on, a heated sapphire substrate together with a carrier gas in an inert gas closed container at atmospheric pressure while the organometallic gas is thermally decomposed on the heated sapphire substrate, thereby forming ZnSe single-crystal on the heated sapphire substrate. Subsequently, a gas of organometallic gallium and a gas of organometallic arsenic corresponding to the composition ratio of a thin film of a GaAs single-crystal compound semiconductor to be fabricated is passed on the obtained ZnSe single-crystal substrate together with a carrier gas while the organometallic gas is thermally decomposed on the ZnSe single-crystal substrate to form a thin film of a GaAs single-crystal compound semiconductor on the ZnSe single-crystal substrate, thereby attaining the manufacture. Metal organic chemical vapor deposition does not require a large and expensive manufacturing apparatus and enables large-area high-speed growth under atmospheric pressure, thereby achieving epitaxial growth at the atomic layer level.

### Industrial Applicability

The present invention, which is a spin-polarized high brightness electron generating photocathode having a simple structure and used for back illumination, can be used as an electron source material for an electronic microscope and an accelerator.

### Reference Signs List

- A: Conventional spin-polarized electron generating device
- B: High brightness electron generating device of the present invention
- 1: NEA active layer
- 2: Intermediate layer and buffer layer
- 3: Substrate
- 4: Irradiation direction of excitation light
- 5: Generation direction of spin-polarized electrons (high brightness electrons)
- 6: Thin film of single-crystal compound semiconductor
- 7: Single-crystal substrate

## Claims

1. A spin-polarized high brightness electron generating photocathode comprising:
a single-crystal substrate that has a nanometer-level flat clean surface and a band gap in a range of 1.5 to 10 eV; and
a thin film of one single-crystal compound semiconductor selected for the substrate, the single-crystal compound semiconductor having a band gap in a range of 0.15 to 6.5 eV and an NEA property and being epitaxially grown on the substrate, wherein
when light in a range of 1.5 to 10 eV is incident on a bottom surface of the single-crystal substrate, an electron beam having an electron beam brightness of about 10⁷ Acm⁻²sr⁻¹ or more is generated from the thin film of the single-crystal compound semiconductor.

2. A spin-polarized high brightness electron generating photocathode comprising:
a single-crystal substrate that has a nanometer-level flat clean surface and a band gap in a range of 1.5 to 10 eV; and
a thin film of one single-crystal compound semiconductor selected for the substrate, the single-crystal compound semiconductor having a band gap in a range of 0.15 to 6.5 eV, an NEA property, and spin-polarized electron generating ability and being epitaxially grown on the substrate, wherein
when light in a range of 1.5 to 10 eV is incident on a bottom surface of the single-crystal substrate, when polarized laser light in a range of 1.5 to 10 eV is incident on the bottom surface of the single-crystal substrate, an electron beam having an electron beam brightness of about 10⁷ Acm⁻²sr⁻¹ or more and a spin polarization degree of about 90% or more is generated from the thin film of the single-crystal compound semiconductor.

3. The spin-polarized high brightness electron generating photocathode according to Claim 1 or 2, wherein the single-crystal compound semiconductor is a GaAs-based single-crystal compound semiconductor and the single-crystal substrate is composed of ZnS or ZnTe.

4. The spin-polarized high brightness electron generating photocathode according to Claim 1 or 2, wherein the single-crystal compound semiconductor is a GaAs-based single-crystal compound semiconductor and the single-crystal substrate is composed of ZnSe.

5. The spin-polarized high brightness electron generating photocathode according to Claim 1 or 2, wherein the single-crystal compound semiconductor is an InSb-based single-crystal compound semiconductor and the single-crystal substrate is composed of one selected from the group consisting of MgTe, CdTe, CdMnTe, and CdZnTe.

6. The spin-polarized high brightness electron generating photocathode according to Claim 1 or 2, wherein the single-crystal compound semiconductor is an InN-based single-crystal compound semiconductor and the single-crystal substrate is composed of one selected from the group consisting of single-crystal diamond and cubic boron nitride.

7. The spin-polarized high brightness electron generating photocathode according to Claim 1 or 2, wherein the single-crystal compound semiconductor is a GaN-based single-crystal compound semiconductor and the single-crystal substrate is composed of one selected from the group consisting of ZnO and hexagonal boron nitride.

8. The spin-polarized high brightness electron generating photocathode according to Claim 1 or 2, wherein the single-crystal compound semiconductor is a CdS-based single-crystal compound semiconductor and the single-crystal substrate is composed of GaN.

9. The spin-polarized high brightness electron generating photocathode according to any one of Claims 1 to 8, wherein the single-crystal compound semiconductor has a thickness of 50 to 500 nm.
